# EUROPÄISCHE PATENTSCHRIFT

(11) **EP 1 016 214 B1**
(45) Veröffentlichungstag und Bekanntmachung des Hinweises auf die Patenterteilung: **05.06.2002**
(21) Anmeldenummer: 98955330.0
(22) Anmeldetag: 15.09.1998
(51) Int. Cl.: H03K 17/16

(54) **VERFAHREN UND VORRICHTUNG ZUM ANSTEUERN EINER INTEGRIERTEN LEISTUNGSENDSTUFE**
METHOD AND DEVICE FOR CONTROLLING AN INTEGRATED POWER AMPLIFIER STAGE
PROCEDE ET DISPOSITIF DE COMMANDE D'UN ETAGE AMPLIFICATEUR DE PUISSANCE INTEGRE

(30) Priorität: 16.09.1997 DE 19740697
(43) Veröffentlichungstag der Anmeldung: 05.07.2000
(73) Patentinhaber: SIEMENS AKTIENGESELLSCHAFT, 80333 München (DE)
(72) Erfinder: ALLMEIER, Franz, D-93098 Mintraching (DE)
(86) Internationale Anmeldenummer: DE9802730
(87) Internationale Veröffentlichungsnummer: WO9914856

(56) Entgegenhaltungen:
- EP-A- 0 509 113
- EP-A- 0 750 112
- EP-A- 0 788 232
- US-A- 4 973 865

## Beschreibung

Die Erfindung betrifft ein Verfahren zum Ansteuern einer integrierten Leistungsendstufe zum Schalten von Lasten nach dem Oberbegriff von Anspruch 1. Die Erfindung betrifft auch eine Vorrichtung zur Durchführung dieses Verfahrens.

Aus US 5,315,174 ist eine solche Vorrichtung zum Ansteuern einer Last mittels einer Leistungsendstufe bekannt, bei welcher die Steilheit der Schaltflanken eines mit der Last in Reihe an den Polen einer Spannungsquelle liegenden Leistungstransistors abhängig von externen Steuersignalen, die auch gespeichert sein können, entweder zunächst steil und anschließend flacher oder nur flach, eistellbar ist.

Aus US 5,568,081 ist eine Vorrichtung zum Ansteuern einer Leistungsendstufe bekannt, bei welcher die Steilheit der Einbzw. Ausschaltflanken der Leistungstransistoren abhängig von externen Steuersignalen eistellbar ist. Zusätzlich können in Perioden des Ausgangssignals, in denen die Ableitung di/dt des Ausgangsstromes nach der Zeit groß ist, flache Ein- und Ausschaltflanken gewählt werden, und in Perioden des Ausgangssignals, in denen die Ableitung di/dt des Ausgangsstromes nach der Zeit klein ist, steile Ein- und Ausschaltflanken gewählt werden.

Aus US 5,617,051 ist eine Einrichtung zum Begrenzen von Spannungsüberschwingern bekannt, bei der die Änderung bzw. Änderungsrate der Ausgangsspannung gemessen wird. Beim Überschreiten vorgegebener Werte erfolgt eine Rückkopplung auf die Ansteuerung derart, daß über eine Abflachung der Schaltflanken eine Reduzierung des Überschwingverhaltens erreicht wird.

Leistungsendstufen werden insbesondere im Motorsteuerungsbereich von Kraftfahrzeugen in großer Zahl verwendet.Je nach Anwendungszweck werden die einzelnen Lasten sporadisch, mit fester Ansteuerfrequenz oder drehzahlabhängig, mit mehr oder weniger exakt einzuhaltenden Schaltzeiten angesteuert. Je genauer die Einschaltzeiten eingehalten werden müssen, umso steilere Anstiegs- und Abfallflanken sind für die Endstufenschalter, welche die Last direkt schalten, erforderlich; Bei weniger zeitkritischen Anwendungen werden den Lasten Freilaufdioden parallelgeschaltet.

Werden die Lasten drehzahlabhängig angesteuert, wobei meistens exakte Einschaltzeiten, beispielsweise für Kraftstoffeinspritzung oder Zündung, gefordert werden, so ist das durch die steilen Flanken der Schaltsignale erzeugte Störspektrum breitbandig. Mit fester Frequenz angesteuerte Lasten bilden eine feste Störfrequenz und sind deshalb kritischer.

Für jede Art der Ansteuerung dieser Lasten sind besonders angepaßte Leistungsendstufen erforderlich. Infolge der großen Zahl benötigter Leistungsendstufen werden integrierte Mehrfachtreiber eingesetzt, z.B. Vier- oder Achtfachtreiber, und in naher Zukunft IC's mit noch mehr Treibern infolge höherer Integrationsdichte, die dem jeweiligen Verwendungszweck mittels externer Bauelemente aufwendig angepaßt werden müssen. Dabei ist es gängige Praxis, die Schaltflanken der Leistungsschalter gerade so steil zu machen, wie es der Verwendungszweck erfordert, um die Störstrahlung so gering wie möglich zu halten.

Es ist Aufgabe der Erfindung, ein Verfahren zum Ansteuern einer integrierten Leistungsendstufe anzugeben, welches es ermöglicht, daß die Leistungsendstufe selbst erkennen kann, ob die zu schaltende Last mit flachen oder steilen Schaltflanken anzusteuern ist und sich selbst darauf einstellt. Aufgabe der Erfindung ist auch, eine Vorrichtung zur Durchführung dieses Verfahrens zu schaffen.

Diese Aufgabe wird erfindungsgemäß durch die in den Ansprüchen 1 und 2 genannten Merkmale gelöst. Vorteilhafte Weiterbildungen der Erfindung sind den Unteransprüchen zu entnehmen.

Die Erfindung wird nachstehend am Beispiel eines Verfahrens und einer Vorrichtung zum Ansteuern einer sich selbst auf steile oder flache Anstiegs- und Abfallflanken einstellenden, integrierten Leistungsendstufe zum Schalten eines induktiven Verbrauchers anhand einer schematischen Zeichnung erläutert.

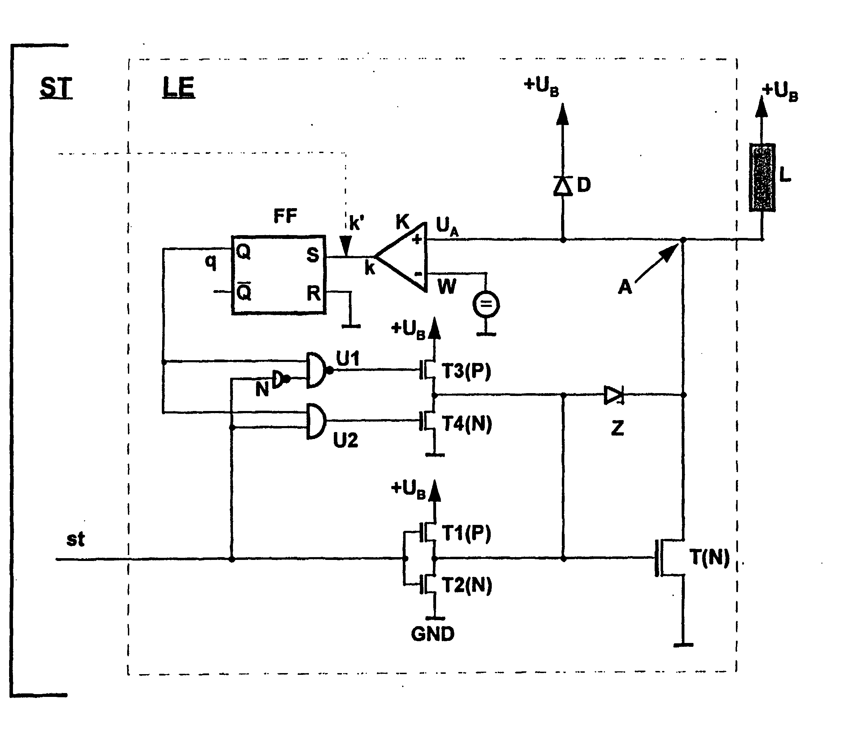

Die einzige Figur zeigt in einem schematischen Schaltbild eine innerhalb eines nur angedeuteten Steuergerätes ST in einem strichlierten Kasten angeordnete integrierte Leistungsendstufe LE, welche eine in diesem Ausführungsbeispiel induktive Last L über einen Endschalter T mittels Steuersignalen st des Steuergerätes ST schaltet. Im Einschaltzustand des Endschalters T wird die einseitig am Pluspol +U_{B} einer Bordspannung liegende Last L mit deren Minuspol GND verbunden, so daß nahezu die gesamte Bordspannung an der Last liegt. Der Einfachheit halber sei angenommen, daß die Bordspannung U_{B} zugleich die Versorgungsspannung des Steuergeräts ST und der Leistungsendstufe ist.

Bei weniger zeitkritischen Anwendungen ist der Last L eine-Freilaufdiode D parallelgeschaltet. In diesem Ausführungsbeispiel sei die Freilaufdiode D als integriertes Bauteil vorgesehen, ihre Katode wird jedoch nicht mit dem Pluspol +U_{B} verbunden, wenn die Last mit steilen Flanken ein- und ausgeschaltet werden soll. Die Freilaufdiode D kann aber auch als externes Bauelement vorgesehen sein.

Beim Abschalten der induktiven Last L unterscheiden sich die Spannungsverläufe am Verbindungspunkt A zwischen Last L und Endschalter T, abhängig davon, ob die Last über eine Freilaufdiode D entregt wird oder nicht. Beim Abschalten mit Freilaufdiode steigt die Spannung U_{A} am Verbindungspunkt A, die während des Einschaltzustandes nahe dem Minuspotential lag, wieder auf das Potential der Bordspannung +U_{B}, beispielsweise +12V, an, bei einer Last ohne Freilaufdiode hingegen auf eine wesentlich höhere Spannung, welche auf die Zenerspannung U_{Z}, beispielsweise +50V, einer zwischen dem Steuereingang des Endschalters T und dem Verbindungspunkt A üblicherweise zum Schutz des Endschalters T angeordneten, integrierten Zenerdiode Z begrenzt wird. An diesen unterschiedlichen Werten der Abschaltspannung am Verbindungspunkt A ist erkennbar, ob die Leistungsendstufe die jeweilige induktive Last mit steilen oder flachen Schaltflanken schalten soll.

Diese Spannungsmessung wird erfindungsgemäß mittels eines Komparators K durchgeführt, dessen einer Eingang mit dem Verbindungspunkt A verbunden ist, und an dessen anderem Eingang ein vorgegebener Spannungs-Schwellwert W von beispielsweise +30V liegt. Der Ausgang des Komparators K ist mit dem Setzeingang S eines RS-Flipflops FF verbunden, dessen Ausgang Q bei jedem Betriebsbeginn auf einem Signalpegel q = L (low) liegt.

Beim Ausschaltvorgang nach dem ersten Ansteuervorgang der Last L bleibt die Spannung U_{A} entweder unterhalb des Schwellwertes W (wenn die Freilaufdiode D parallel zur Last L geschaltet ist, das Komparatorausgangssignal k = L ) oder sie übersteigt den Schwellwert W (wenn ohne Freilaufdiode D mit steilen Flanken geschaltet wird).

In letzterem Fall (steile Flanken) wird das RS-Flipflop FF durch das Ausgangssignal k = H (high) des Komparators K gesetzt, d.h., dessen Ausgang Q wird auf einen Signalpegel q = H (high) gesetzt; andernfalls (flache Flanken) bleibt der Ausgang Q auf Signalpegel q = L. Dieser Wert q = L oder q = H bleibt während des gesamten Betriebslaufs im RS-Flipflop FF gespeichert.

Das im Steuergerät ST erzeugte Steuersignal st wird den Steuereingängen eines aus zwei in Reihe zwischen Pluspol +U_{B} und Minuspol GND der Bordspannung liegenden Treiber-Schaltern T1 und T2 bestehenden ersten Treibers zugeführt.

Mit dem Ausgang Q des RS-Flipflops FF ist eine Schaltlogik verbunden, bestehend aus einem NAND-Glied U1, einem UND-Glied U2 sowie einem Inverter N, welche die Schaltgeschwindigkeit des Endschalters T entsprechend den Signalen q und st steuert.

Der Ausgang Q des RS-Flipflops FF ist mit je einem Eingang des NAND-Gliedes U1 und des UND-Gliedes U2 verbunden. Dem anderen Eingang des UND-Gliedes U2 wird das Steuersignal st direkt, und dem anderen Eingang des NAND-Gliedes U1 über den Inverter N zugeführt.

Die in der Figur schematisch dargestellten Schalter T und T1 bis T4 seien in diesem Ausführungsbeispiel als integrierte MOSFET-Schalter ausgeführt (T1 und T3 als P-Kanal-MOSFET's, welche leitend sind, wenn an ihrem Steuereingang ein L-Signal anliegt; sowie T, T2 und T4 als N-Kanal-MOSFET's, welche leitend sind, wenn an ihrem Steuereingang ein H-Signal anliegt), wobei T1 bis T4 als schaltbare Widerstände aufzufassen sind, welche mit der Eingangskapazität des Endschalters T ein RC-Glied bilden. Die Treiber-Schalter T1 bis T4 könnten beispielsweise auch als Bipolarschalter in Reihenschaltung mit je einem (wegen schlechter Integrationsmöglichkeit gegebenenfalls externen) Widerstand oder je einer Stromquelle ausgeführt sein.

Die Größe des über den Steuereingang des Endschalters T fließenden Stromes (von +U_{B} oder nach GND) bestimmt die Geschwindigkeit, mit der dieser leitend oder nichtleitend wird. In der Zeichnung ist die Ausführung als P- oder N-Kanal-MOSFET-Schalter hinter den Bezugszeichen von T und T1 bis T4 in Klammern gesetzt.

Selbstverständlich ist die beschriebene Leistungsendstufe LE mit entsprechenden Schaltelementen auch in "invertierter Logik", bei der die Last mit dem Minuspol GND verbunden ist und der Endschalter T als Highside-Schalter ausgebildet ist, ausführbar.

Weiterhin ist ein zweiter Treiber vorgesehen, bestehend aus den bereits erwähnten Treiber-Schaltern T3 und T4, welche ebenfalls in Reihe zwischen Pluspol +U_{B} und Minuspol GND der Bordspannung liegen, und die von der beschriebenen Schaltlogik angesteuert werden. Der Steuereingang des Treiber-Schalters T3 ist mit dem Ausgang des NAND-Gliedes U1 verbunden, während der Steuereingang des Treiber-Schalters T4 mit dem Ausgang des UND-Gliedes U2 verbunden ist. Der Verbindungspunkt beider Treiber-Schalter T3 und T4 ist, wie der des ersten Treibers, mit dem Steuereingang des Endschalters T verbunden.

Das Steuersignal st ist in diesem Ausführungsbeispiel ein invertiertes Signal, d.h., der Endschalter T soll leitend sein, wenn st = L; und soll nichtleitend sein, wenn st = H.

Ist das Ausgangssignal q des RS-Flipflops FF q = L, so steht am Ausgang des NAND-Gliedes U1 ein H-Signal und am Ausgang des UND-Gliedes U2 ein L-Signal. Die beiden Treiber-Schalter T3 und T4 sind nichtleitend. Mit Erscheinen eines Steuersignals st = L wird Treiber-Schalter T1 leitend und Treiber-Schalter T2 nichtleitend, wodurch der Endschalter T mit einem Strom (von +U_{B} über T1) angesteuert wird, durch welchen er mit flacher Anstiegsflanke leitend wird. Beim Verschwinden des Steuersignals st = 1 wird Treiber-Schalter T1 nichtleitend und Treiber-Schalter T2 leitend, wodurch der Endschalter T mit flacher Abfallflanke wieder nichtleitend wird.

Ist das Ausgangssignal q des RS-Flipflops FF q = H, so werden mit Erscheinen eines Steuersignals st = L gleichzeitig die Treiber-Schalter T1 und T3 parallelgeschaltet und leitend, wodurch der Endschalter T mit einem höheren Strom angesteuert wird, als zuvor bei q = L beschrieben (da jetzt T1 und T3 mit geringerem Gesamtwiderstend parallel liegen), wobei der Endschalter T mit steiler Anstiegsflanke leitend wird. Beim Verschwinden des Steuersignals (st =H) werden die Treiber-Schalter T1 und T3 nichtleitend (der Ausgang des UND-Gliedes U2 geht infolge des Inverters N auf H-Signal). Damit werden die jetzt parallel geschalteten Treiber-Schalter T2 und T4 leitend, wobei der Endschalter T mit steiler Abfallflanke nichtleitend wird.

Die beschriebene Leistungsendstufe eignet sich nicht nur für induktive, sondern auch für Ohm'sche Lasten. In diesem Fall wird der Schwellwert W beim ersten Abschalten der Last L nach Betriebsbeginn nicht überschritten, die Last wird dementsprechend mit flachen Flanken angesteuert.

## Patentansprüche

1. Verfahren zum Ansteuern einer integrierten Leistungsendstufe zum Schalten einer mit einem Endschalter (T) dieser Leistungsendstufe in Reihenschaltung an den Polen (+U_{B}, GND) einer Spannungsquelle liegenden, mit oder ohne Freilaufdiode (D) beschalteten Last (L) mit steilen oder flachen Ein- und Ausschaltflanken mittels Steuersignalen (st) eines Steuergerätes (ST),
**dadurch gekennzeichnet,**
**daß** die am Verbindungspunkt (A) zwischen Last (L) und Endschalter (T) beim Abschalten der Last (L) meßbare Spannung (U_{A}) mit einem vorgegebenen Schwellwert (W) verglichen wird,
**daß** ein dem Vergleichsergebnis zugeordneter Wert (q) während des Betriebslaufs gespeichert wird, und
**daß** der Endschalter (T) mit einem vorgegebenen, flachen Einund Ausschaltflanken zugeordneten Strom leitend und nichtleitend gesteuert wird, wenn der Wert q einen ersten, niedrigen Signalpegel aufweist, und mit einem höheren, steilen Ein- und Ausschaltflanken zugeordneten Strom leitend und nichtleitend gesteuert wird, wenn der Wert q einen zweiten, hohen Signalpegel aufweist.

2. Vorrichtung zur Durchführung des Verfahrens nach Anspruch 1, **dadurch gekennzeichnet,**
**daß** ein erster Treiber vorgesehen ist, bestehend aus zwei Treiber-Schaltern (T1, T2), die in Reihenschaltung zwischen Pluspol (+U_{B}) und Minuspol (GND) der Bordspannung liegen, deren Steuereingängen das Steuersignal (st) zugeführt wird, und deren Verbindungspunkt mit dem Steuereingang des Endschalters (T) verbunden ist,
**daß** ein Komparator (K) vorgesehen ist, dessen einer Eingang mit dem Verbindungspunkt (A) zwischen Last (L) und Endschalter (T) verbunden ist, und dessen anderem Eingang ein Schwellwert (W) zugeführt ist,
**daß** ein RS-Flipflop (FF) vorgesehen ist, dessen Setzeingang (S) mit dem Ausgang des Komparators (K) verbunden ist, und dessen Rücksetzeingang mit dem Minuspol (GND) verbunden ist,
**daß** eine Schaltlogik vorgesehen ist, bestehend aus einem NAND-Glied (U1), einem UND-Glied (U2) sowie einem Inverter (N), wobei der Ausgang (Q) des RS-Flipflops (FF) mit je einem Eingang des NAND-Gliedes (U1) und des UND-Gliedes (U2) verbunden ist, und wobei das Steuersignal (st) dem anderen Eingang des UND-Gliedes (U2) direkt und dem anderen Eingang des NAND-Gliedes (U1) über den Inverter (N) zugeführt wird, und
**daß** ein zweiter Treiber vorgesehen ist, bestehend aus zwei Treiber-Schaltern (T3, T4), die in Reihenschaltung zwischen Pluspol (+U_{B}) und Minuspol (GND) der Bordspannung liegen, wobei der Steuereingang des Treiber-Schalters (T3) mit dem Ausgang des NAND-Gliedes (U1) und der Steuereingang des Treiber-Schalters (T4) mit dem Ausgang des UND-Gliedes (U2) verbunden ist, und wobei der Verbindungspunkt der beiden Treiber-Schalter (T3, T4) mit dem Steuereingang des Endschalters (T) verbunden ist.

3. Vorrichtung nach Anspruch 2, **dadurch gekennzeichnet, daß** der Endschalter (T) und die Treiber-Schalter (T1 bis T4) integrierte MOSFET-Schalter sind.

4. Vorrichtung nach Anspruch 3, **dadurch gekennzeichnet, daß** die Treiber-Schalter (T1 und T3) als P-Kanal-MOSFET's, der Endschalter (T1) und die Treiber-Schalter (T2 und T4) hingegen als N-Kanal-MOSFET's ausgeführt sind.

5. Vorrichtung nach Anspruch 2, **dadurch gekennzeichnet, daß** die Treiber-Schalter (T1 bis T4) als Bipolartransistoren ausgeführt sind, wobei mit jedem Transistor ein Widerstand oder eine Stromquelle in Reihe geschaltet ist.

6. Vorrichtung nach Anspruch 2, **dadurch gekennzeichnet, daß** der Setzeingang (S) des RS-Flipflops (FF) mit einem ein Ausgangssignal (k' = 1 oder H) liefernden Ausgang des Steuergerätes (ST) verbunden ist.

7. Vorrichtung nach Anspruch 2, **dadurch gekennzeichnet, daß** die Steuereingänge der Treiberschalter (T3 und T4) direkt mit Ausgängen des Steuergerätes (ST) verbunden sind, von welchen sie mit Ansteuersignalen mit einer der gewünschten Steilheit zugeordneten Amplitude beaufschlagt werden.

## Claims

1. Method for driving an integrated power output stage for switching a load (L), which is connected to the terminals (+U_{B}, GND) of a voltage source in series with a limit switch (T) in this power output stage and is wired up with or without a freewheeling diode (D), with steep or shallow turn-on and turn-off edges using control signals (st) from a control unit (ST),
**characterized**
**in that** the voltage (U_{A}) which can be measured at the junction point (A) between the load (L) and the limit switch (T) when the load (L) is disconnected is compared with a predetermined threshold value (W),
**in that** a value (q) associated with the comparison result is stored over the course of operation, and
**in that** the limit switch (T) is turned on and off with a predetermined current associated with shallow turn-on and turn-off edges when the value q has a first, low signal level, and is turned on and off with a higher current associated with steep turn-on and turn-off edges when the value q has a second, high signal level.

2. Device for carrying out the method according to Claim 1, **characterized**
**in that** a first driver is provided, comprising two driver switches (T1, T2) which are connected in series between the positive terminal (+U_{B}) and the negative terminal (GND) of the on-board voltage, whose control inputs are supplied with the control signal (st) and whose junction point is connected to the control input of the limit switch (T),
**in that** a comparator (K) is provided whose one input is connected to the junction point (A) between the load (L) and the limit switch (T) and whose other input is supplied with a threshold value (W),
**in that** an RS flipflop (FF) is provided whose Set input (S) is connected to the output of the comparator (K) and whose Reset input is connected to the negative terminal (GND),
**in that** a switching logic circuit is provided, comprising a NAND gate (U1), an AND gate (U2) and an inverter (N), the output (Q) of the RS flipflop (FF) being connected to a respective input of the NAND gate (U1) and of the AND gate (U2), and the control signal (st) being supplied to the other input of the AND gate (U2) directly and to the other input of the NAND gate (U1) via the inverter (N), and
**in that** a second driver is provided, comprising two driver switches (T3, T4) connected in series between the positive terminal (+U_{B}) and the negative terminal (GND) of the on-board voltage, the control input of the driver switch (T3) being connected to the output of the NAND gate (U1), the control input of the driver switch (T4) being connected to the output of the AND gate (U2), and the junction point between the two driver switches (T3, T4) being connected to the control input of the limit switch (T).

3. Device according to Claim 2, **characterized in that** the limit switch (T) and the driver switches (T1 to T4) are integrated MOSFET switches.

4. Device according to Claim 3, **characterized in that** the driver switches (T1 and T3) are P-channel MOSFETs, whereas the limit switch (T1) and the driver switches (T2 and T4) are N-channel MOSFETs.

5. Device according to Claim 2, **characterized in that** the driver switches (T1 to T4) are bipolar transistors, each transistor having a resistor or a current source connected in series with it.

6. Device according to Claim 2, **characterized in that** the Set input (S) of the RS flipflop (FF) is connected to an output of the control unit (ST) which delivers an output signal (k' = 1 or H).

7. Device according to Claim 2, **characterized in that** the control inputs of the driver switches (T3 and T4) are directly connected to outputs of the control unit (ST) which apply to them driving signals having an amplitude which is associated with the desired steepness.

## Revendications

1. Procédé destiné à commander un étage intégré de sortie de puissance pour mettre en circuit une charge (L), équipée ou non d'une diode de roue libre (D), connectée en série avec un commutateur de sortie (T) de cet étage de sortie de puissance sur les pôles (+U_{B}, GND) d'une source de tension, avec des flancs positifs et négatifs raides ou plats, au moyen de signaux de commande (st) d'un appareil de commande (ST)
**caractérisé par le fait**
**que** la tension (U_{A}) qui peut être mesurée, lors de la déconnexion de la charge (L), au point commun (A) entre la charge (L) et le commutateur de sortie (T), est comparée à une valeur de seuil (W) prédéterminée,
**qu'**une valeur (q) correspondant au résultat de la comparaison est mémorisée au cours du fonctionnement et
**que** le commutateur de sortie (T) est commandé, par un courant prédéterminé correspondant à des flancs positifs et négatifs plats, dans un état conducteur et dans un état non conducteur lorsque la valeur q a un premier niveau bas de signal, et, par un courant plus élevé correspondant à des flancs positifs et négatifs raides, dans un état conducteur et dans un état non conducteur lorsque la valeur q a un deuxième niveau élevé de signal.

2. Dispositif destiné à l'exécution du procédé selon la revendication 1 **caractérisé par le fait**
**qu'**il est prévu un premier pilote, composé de deux commutateurs pilotes (T1, T2), placés en série entre le pôle plus (+U_{B}) et le pôle moins (GND) de la tension de bord, aux entrées de commande desquels est appliqué le signal de commande (st) et dont le point commun est relié à l'entrée de commande du commutateur de sortie (T),
**qu'**il est prévu un comparateur (K) dont une entrée est reliée au point commun (A) entre la charge (L) et le commutateur de sortie (T) et sur l'autre entrée duquel est appliquée une valeur de seuil (W),
**qu'**il est prévu une bascule SR bistable (FF), dont l'entrée d'assignation (S) est reliée à la sortie du comparateur (K) et dont l'entrée de remise à zéro est reliée au pôle moins (GND),
**qu'**il est prévu une logique de commutation composée d'un élément NON-ET (U1), d'un élément ET (U2), ainsi que d'un inverseur (N), la sortie (Q) de la bascule SR bistable (FF) étant reliée à une entrée de l'élément NON-ET (U1) et à une entrée de l'élément ET (U2) et le signal de commande (st) étant appliqué directement à l'autre entrée de l'élément ET (U2) et, par l'intermédiaire de l'inverseur (N), à l'autre entrée de l'élément NON-ET (U1) et
**qu'**il est prévu un deuxième pilote, composé de deux commutateurs pilotes (T3, T4), placés en série entre le pôle plus (+U_{B}) et le pôle moins (GND) de la tension de bord, l'entrée de commande du commutateur de pilote (T3) étant reliée à la sortie de l'élément NON-ET (U1) et l'entrée de commande du commutateur de pilote (T4) étant relié à la sortie de l'élément ET (U2) et le point commun des deux commutateurs pilotes (T3, T4) étant reliés à l'entrée de commande du commutateur de sortie (T).

3. Dispositif selon la revendication 2 **caractérisé par le fait que** le commutateur de sortie (T) et les commutateurs pilotes (T3, T4) sont des commutateurs MOSFET intégrés.

4. Dispositif selon la revendication 3 **caractérisé par le fait que** les commutateurs pilotes (T1 et T3) sont réalisés sous forme de MOSFET à canal P, par contre, le commutateur final (T1) et les commutateurs pilotes (T2 et T4) sont réalisés sous forme de MOSFET à canal N.

5. Dispositif selon la revendication 2 **caractérisé par le fait que** les commutateurs pilotes (T1 à T4) sont réalisés comme transistors bipolaires, une résistance ou une source de courant étant raccordées en série à chaque transistor.

6. Dispositif selon la revendication 2 **caractérisé par le fait que** l'entrée d'assignation (S) de la bascule SR bistable (FF) est reliée à une sortie de l'appareil de commande (ST) qui délivre un signal de sortie (k' = L ou H).

7. Dispositif selon la revendication 2 **caractérisé par le fait que** les entrées de commande des commutateurs pilotes (T3 et T4) sont reliées directement aux sorties de l'appareil de commande (ST) à partir desquelles elles reçoivent des signaux de commande ayant une amplitude correspondant à la pente souhaitée.
